(19) **Europäisches Patentamt / European Patent Office / Office européen des brevets**

(11) **EP 1 071 210 B1**

(12) **EUROPÄISCHE PATENTSCHRIFT**

(45) Veröffentlichungstag und Bekanntmachung des Hinweises auf die Patenterteilung:
**28.01.2009   Patentblatt 2009/05**

(51) Int Cl.:
**H03K 17/042** (2006.01)

(21) Anmeldenummer: **00113731.4**

(22) Anmeldetag: **28.06.2000**

(54) **Schaltungsanordnung**

Cicuit arrangement

Montage de circuit

(84) Benannte Vertragsstaaten:
**AT BE CH CY DE DK ES FI FR GB GR IE IT LI LU MC NL PT SE**

(30) Priorität: **20.07.1999   DE 19933161**

(43) Veröffentlichungstag der Anmeldung:
**24.01.2001   Patentblatt 2001/04**

(73) Patentinhaber: **Patent-Treuhand-Gesellschaft für elektrische Glühlampen mbH
81543 München (DE)**

(72) Erfinder: **Franck, Felix
80333 München (DE)**

(74) Vertreter: **Raiser, Franz
Osram GmbH
Postfach 22 16 34
80506 München (DE)**

(56) Entgegenhaltungen:
DE-A1- 4 436 465          DE-A1- 19 728 295
US-A- 4 481 434          US-A- 5 834 964

**Beschreibung**

**Technisches Gebiet**

Die vorliegende Erfindung betrifft eine Schaltungsanordnung mit mindestens einem elektrischen Hauptschalter mit einer Bezugselektrode, einer Steuerelektrode und einer Arbeitselektrode, und einer Freilaufdiode, die zur Hauptstromflußrichtung eines jeden Hauptschalters antiparallel geschaltet ist.

Allgemein in der Elektronik, speziell jedoch in der Leistungselektronik besteht das Bedürfnis, bei möglichst geringem Platzbedarf möglichst große Leistungen verarbeiten zu können. Dies geht einher mit der Forderung, auftretende Verlustleistung minimal zu halten, da Verlustleistung in Wärme umgesetzt wird, daher (größere) Kühlkörper und somit größere Gehäusedimensionierungen erfordert. Beispielsweise bei fremdgesteuerten und selbstgesteuerten Transistorwechselrichtern ist die auftretende Verlustleistung um so geringer, je schärfer und schneller die Schaltvorgänge der Transistoren ablaufen. Insbesondere bei Verwendung von bipolaren Schalttransistoren ist die Erzielung kurzer Schaltvorgänge besonders schwierig. Auch wenn die Erfindung auf Schaltungen mit Feldeffekttransistoren anwendbar ist, wird im nachfolgenden die Problematik und die erfindungsgemäße Lösung am Beispiel von Bipolartransistoren dargestellt werden.

**Stand der Technik**

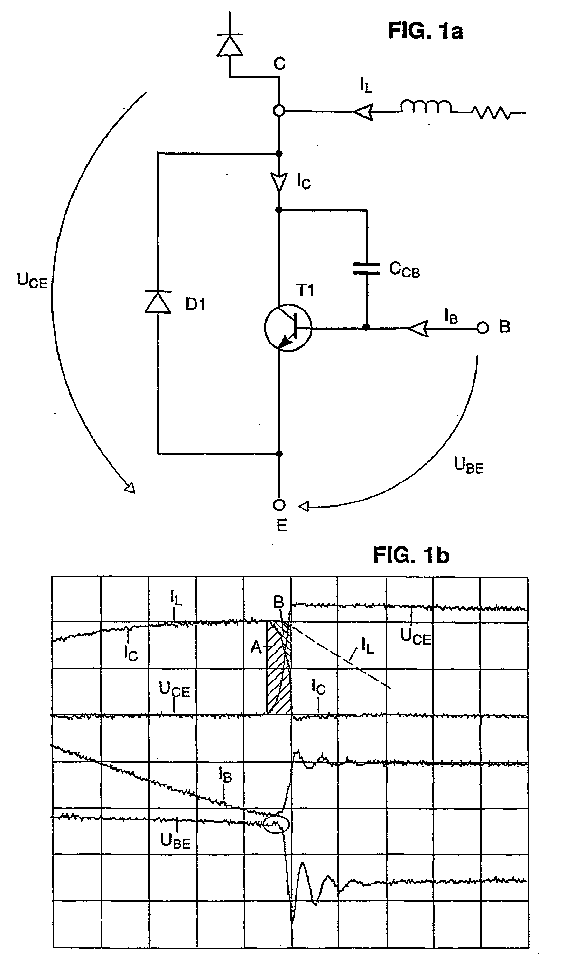

Zunächst wird mit Bezug auf Fig. 1a die der Erfindung zugrundeliegende Problematik vorgestellt. Fig. 1a zeigt die aus dem Stand der Technik bekannte Standardsituation eines Leistungsschalttransistors T1, vorliegend ein Bipolartransistor, dem eine Freilaufdiode D1 antiparallel geschaltet ist. Die drei von außen zugänglichen Anschlüsse des Transistors sind mit C für Kollektor (Arbeitselektrode), B für Basis (Steuerelektrode) und E für Emitter (Bezugselektrode) bezeichnet. Die zwischen Kollektor und Emitter abfallende Spannung sei mit $U_{CE}$, die zwischen Basis und Emitter abfallende Spannung mit $U_{BE}$, der in den Kollektor fließende Strom mit $I_C$ und der in die Basis fließende Strom mit $I_B$ bezeichnet. Zwischen Kollektor und Basis ist eine parasitäre Kapazität, die sogenannte Millerkapazität $C_{CB}$ vorhanden. Dies gilt in entsprechender Weise auch für Feldeffekttransistoren. Die während eines Schaltvorgangs maßgebliche Verlustleistung wird bestimmt durch das Produkt $I_C \times U_{CE}$. In Fig. 1b ist der Verlauf nicht nur dieser beiden Größen, sondern auch der Verlauf der Basis-Emitter-Spannung $U_{BE}$ und des Basisstroms $I_B$ über der Zeit dargestellt. Ein relativ verlustfreier, somit erwünschter Schaltvorgang ist dadurch gekennzeichnet, daß, sobald $U_{CE}$ zu steigen beginnt, der Kollektorstrom $I_C$ stark fällt. Der für die Schaltung gemäß Fig. 1a und Fig. 1b dargestellte zeitliche Verlauf der Größen $I_C$ und $U_{CE}$ genügt dieser Bedingung aus den folgenden Gründen nicht: Zunächst sei für die nachfolgenden Betrachtungen angenommen, daß der Emitter des Transistors T1 auf Masse liegt. Geht daher die Spannung am Kollektor nach oben, d.h. steigt $U_{CE}$, wird aufgrund des Ladestroms durch die Millerkapazität $C_{CB}$ und aufgrund der spannungsbezogenen "Weichheit" des Basisanschlusses die Basisspannung $U_{BE}$ "mitgenommen", d.h. $U_{BE}$ vergrößert sich ebenfalls (siehe Kreis in Fig. 1b) anstatt abzunehmen. Da die Basissteuerung eine sogenannte Stromquellencharakteristik aufweist, wirkt der die Millerkapazität $C_{CB}$ ladende Strom gegenkoppelnd auf die Basiselektrode des Transistors T1. Der Ausschaltvorgang verlangsamt sich dadurch stark: während $U_{CE}$ bereits ansteigt, ist $I_C$ noch in fast voller Höhe vorhanden. Deutlich wird dies auch durch den konvexen Kurvenverlauf des Stroms $I_C$ während des Abschaltvorgangs. Die mit A bezeichnete schraffierte Fläche entspricht der Ladung, die noch durch den Transistor fließt, obwohl dieser bereits "abgeschaltet" ist. Gestrichelt eingezeichnet ist der Verlauf des Stroms $I_L$ durch eine ohmschinduktive Last, die an der Arbeitselektrode des Hauptschalters angeschlossen ist. Demnach wird die durch die Flache B gekennzeichnete Ladung für den Umladevorgang durch Transistorkapazitäten (nicht dargestellt) bereitgestellt. Das Verhältnis aus der Fläche A zur Fläche B, d.h. des Ausschaltstroms zum Umladestrom kann als Maß für die Verluste des Umschaltvorgangs angesehen werden. Je geringer A zu B, desto geringere Verluste entstehen bei einem Umschaltvorgang.

Bisherige Lösungen zur Beschleunigung derartiger Ausschaltvorgänge sahen einerseits vor, einen Widerstand in einer Größenordnung von weniger als 100 $\Omega$ parallel zur Basis-Emitter-Strecke, andererseits eine Serienschaltung aus einem Kondensator mit einer Kapazität $\leq 10$ nF und einem Widerstand $\leq 100$ $\Omega$ parallel zur Basis-Emitter-Strecke zu schalten. Die Ergebnisse dieser Lösungen sind jedoch unbefriedigend, da die Ausschaltverluste nach wie vor zu groß sind.

**Darstellung der Erfindung**

Die Aufgabe der vorliegenden Erfindung besteht deshalb darin, eine Schaltungsanordnung der eingangs genannten Art derart weiterzubilden, daß die bei einem Ausschaltvorgang des Hauptschalters auftretenden Verluste möglichst gering ausfallen.

Zur Lösung dieser Aufgabe sieht die Erfindung vor, daß jedem Hauptschalter ein elektrischer Hilfsschalter zugeordnet wird, dessen Arbeitselektrode mit der Steuerelektrode des zugehörigen Hauptschalters und dessen Bezugselektrode mit der Bezugselektrode des zugehörigen Hauptschalters verbunden ist, wobei zwischen der Steuerelektrode des Hilfsschalters und der Arbeitselektrode des zugehörigen Hauptschalters mindestens ein Kondensator angeordnet ist, und wobei zwischen der Steuerelektrode und der Bezugselektrode des Hilfsschalters eine Entladeeinheit derart angeordnet ist, daß der Kondensator während des Übergangs des Hauptschalters vom AUS- in den EIN-Zustand entladen werden kann.

Die erfindungsgemäße Lösung macht sich die Erkenntnis zunutze, daß eine Spannungserhöhung an der Arbeitselektrode des Hauptschalters über einen Kondensator zur Steuerelektrode des Hilfsschalters übertragen werden kann. Bei geeigneter Wahl des Hilfsschalters löst der Ladevorgang des Kondensators dessen Übergang in den EIN-Zustand aus. Da die Arbeitselektrode des Hilfsschalters mit der Steuerelektrode des Hauptschalters verbunden ist, werden dadurch aktiv Ladungsträger aus der Steuerelektrode des Hauptschalters abgezogen. Dem den Ausschaltvorgang des Hauptschalters verzögernden Einfluß der Millerkapazität $C_{CB}$ läßt sich hierdurch entgegenwirken. Dies führt zu einer deutlichen Beschleunigung des Ausschaltvorgangs und damit zu deutlich geringeren Verlusten als bei den Lösungen des Stands der Technik. Die Entladeeinheit dient dazu, den Kondensator zwischen den Ausschaltvorgängen zu entladen, damit er für den nachfolgenden Ausschaltvorgang wieder zur Verfügung steht, d.h. wieder geladen werden kann.

In ihrer einfachsten Ausbildung besteht die Entladeeinheit aus einem einzigen Widerstand. Bei einer alternativen Realisierung kann die Entladeeinheit eine Entladediode umfassen, vorzugsweise realisiert als Schottky-Diode, Zenerdiode oder pn-Diode, wobei der Entladediode mindestens ein Widerstand seriell und/oder parallel geschaltet sein kann. Die Entladeeinheit kann über einen SHUT-DOWN-Eingangsanschluß verfügen, über den ein den Hilfsschalter in den EIN-Zustand schaltendes Signal anlegbar ist. Vorzugsweise umfaßt die Verbindung des SHUT-DOWN-Eingangsanschlusses mit der Steuerelektrode des Hilfsschalters eine SHUT-DOWN-Diode, die mit Bezug auf die Steuerelektrode des Hilfsschalters wie die Entladediode orientiert ist. Die SHUT-DOWN-Diode kann als pn- oder Schottky-Diode realisiert sein.

Die Entladeeinheit kann einen SENSE-Ausgangsanschluß aufweisen, der mit der Steuerelektrode des Hilfsschalters verbunden ist, so daß über den SENSE-Ausgangsanschluß der Schaltstatus des Haupt- und/oder Hilfsschalters abfragbar ist. Zwischen dem SENSE-Ausgangsanschluß und der Steuerelektrode des Hilfsschalters kann mindestens ein Kondensator zur Potentialverschiebung angeordnet sein.

Die erfindungsgemäße Schaltungsanordnung kann weiterhin eine Antisättigungseinheit aufweisen, die zwischen Arbeitselektrode und Steuerelektrode des Hilfsschalters angeordnet ist und eine Sättigung der Steuerelektrode des Hilfsschalters verhindert. In ihrer einfachsten Ausgestaltung kann die Antisättigungseinheit durch einen einzelnen Widerstand realisiert sein, der derart angeordnet ist, daß im Falle der Sättigung der Steuerelektrode des Hilfsschalters Ladungsträger zur Arbeitselektrode des Hilfsschalters abfließen können. Bei einer alternativen, besonders bevorzugten Ausführungsform kann die Antisättigungseinheit eine Antisättigungsdiode aufweisen, die derart angeordnet ist, daß sie denselben Zweck erfüllt. Die Antisättigungsdiode kann hierbei als pn- oder Schottky-Diode realisiert sein, wobei der Antisättigungsdiode mindestens ein Widerstand seriell und/oder parallel geschaltet sein kann.

Der Hauptschalter kann als Bipolartransistor realisiert sein, er kann jedoch auch zusammen mit der zugehörigen Freilaufdiode durch einen MOSFET realisiert sein. Als Hilfsschalter kommen in Betracht ein Bipolartransistor, ein Bipolartransistor mit Seriendiode im Kollektor, ein MOSFET oder ein MOSFET mit Seriendiode in der Drain, wobei bei Verwendung einer Seriendiode deren Orientierung so erfolgt, daß ein Stromfluß in der Hauptstromflußrichtung des zugehörigen Hilfsschalters ermöglicht wird. Diese Seriendiode ist vorzugsweise durch eine Schottky-Diode realisiert.

Die Erfindung umfaßt auch eine Brückenschaltung mit mindestens einer ersten und einer zweiten erfindungsgemäßen Schaltungsanordnung, wobei von der ersten und von der zweiten Schaltungsanordnung eine Brücke dadurch gebildet wird, daß die Bezugselektrode des Hauptschalters der zweiten ("oberen") Schaltungsanordnung mit der Arbeitselektrode des Hauptschalters der ersten ("unteren") Schaltungsanordnung, gegebenenfalls unter Zwischenschaltung weiterer Bauelemente, verbunden ist. Eine derartige Brückenschaltung kann Teil einer freischwingenden Oszillatorschaltung zum Betreiben einer Last sein, die weiterhin eine Schaltsteuereinrichtung zur Rückkopplung des Laststroms auf die Steuerelektroden der Hauptschalter der ersten und zweiten Schaltungsanordnung aufweisen kann, wobei die Steuerelektrode jedes Hauptschalters mit der Schaltsteuereinrichtung durch jeweils eine Anschlußleitung verbunden ist und die beiden Anschlußleitungen ihrerseits über mindestens einen sogenannten Basisbrückenkondensator miteinander verbunden sind. Die Schaltsteuereinnchtung kann als Steuertransformator ausgebildet sein. Der Basisbrückenkondensator kann jeweils direkt an der Steuerelektrode jedes Hauptschalters und/oder jeweils direkt an dem der Steuerelektrode des jeweiligen Hauptschalters zugewandten Ausgang der Schaltsteuereinrichtung angeschlossen sein.

Weitere vorteilhafte Weiterbildungen können den Unteransprüchen entnommen werden.

**Beschreibung der Zeichnungen**

Im folgenden werden Ausführungsbeispiele unter Hinweis auf die beigefügten Zeichnungen näher beschrieben. Es stellen dar:

Fig. 1a    Zur Definition einiger Größen als Ausgangssituation die Beschaltung eines Leistungstransistors mit Freilaufdiode, wie sie aus dem Stand der Technik bekannt ist;

Fig. 1b    die zeitlichen Verläufe des Kollektorstroms $I_C$, der Kollektor-Emitter-Spannung $U_{CE}$, der Basis-Emitter-Spannung $U_{BE}$ sowie des Basisstroms $I_B$ für einen Ausschaltvorgang des Leistungstransistors von Fig. 1a;

Fig. 2a      eine sehr einfache Ausführungsform einer erfindungsgemäßen Schaltungsanordnung;

Fig. 2b      die zeitlichen Verläufe des Kollektorstroms $I_C$, der KollektorEmitter-Spannung $U_{CE}$, der Basis-Emitter-Spannung $U_{BE}$ sowie des Basisstroms $I_B$ für einen Ausschaltvorgang der Schaltungsanordnung von Fig. 2a;

Fig. 3      ein Prinzipschaltbild für erfindungsgemäße Schaltungsanordnungen;

Fig. 4      ein Schaltungsbeispiel für die Entladeeinheit;

Fig. 5      ein Schaltungsbeispiel mit zwei erfindungsgemäßen Schaltungsanordnungen, beispielhaft angewendet bei einem Wechselrichter;

Fig. 6      den zeitlichen Verlauf verschiedener Größen des Schaltungsbeispiels von Fig. 5.

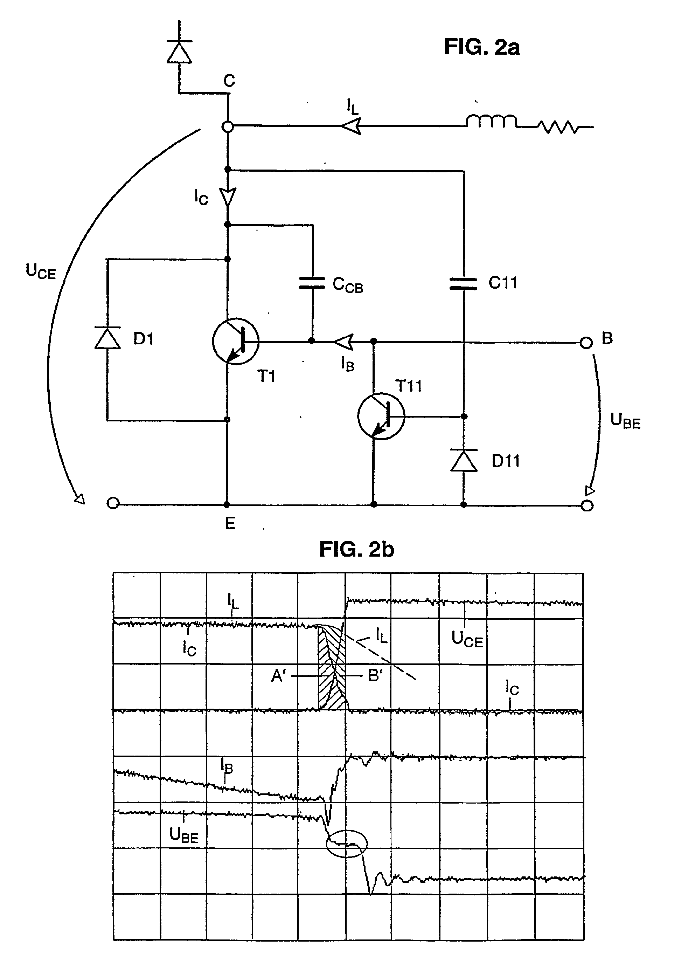

Fig. 2a zeigt die Schaltungsanordnung von Fig. 1a, erweitert gemäß der vorliegenden Erfindung, wobei für die nachfolgenden Betrachtungen mit Bezug auf Transistor T1 dessen Kollektor seine Arbeitselektrode, dessen Basis seine Steuerelektrode und dessen Emitter seine Bezugselektrode, mit Bezug auf Transistor T11 dessen Kollektor seine Arbeitselektrode, dessen Basis seine Steuerelektrode und dessen Emitter seine Bezugselektrode sei: Dem Transistor T1 ist als Hilfsschalter der Transistor T11 zugeordnet, dessen Arbeitselektrode mit der Steuerelektrode von Transistor T1 verbunden ist. Der Emitter von Transistor T11 ist mit der Bezugselektrode von Transistor T1 verbunden. Die Steuerelektrode des Transistors T11 ist zum einen über einen Kondensator C11 mit der Arbeitselektrode von Transistor T1, zum andern über eine Entladediode D11 mit den Bezugselektroden der beiden Transistoren verbunden.

Zur Funktion der Schaltungsanordnung von Fig. 2a: Sobald $U_{CE}$ zu steigen beginnt, wird die Basis des Hilfstransistors T11 von dem den Mitkoppelkondensator C11 ladenden Strom durchströmt. Dadurch wird der Hilfstransistor T11 eingeschaltet, wodurch die Basis des Haupttransistors T1 niederohmig mit dem Emitter des Hilfstransistors T11 verbunden wird. Dadurch können Ladungsträger aus dem Kollektor-Basis-Übergang des Haupttransistors T1 über den Hilfstransistor T11 abfließen.

Mit Bezug auf Fig. 2b wird deutlich, daß diese Beschaltungsmaßnahme zu einem deutlich verlustärmeren Ausschaltvorgang führt als die Schaltungsanordnung gemäß Fig. 1a: Der Abfluß der Ladungsträger aus dem Kollektor-Basis-Übergang von T1 kann in Fig. 2b an der negativen Spitze im Verlauf des Basisstroms $I_B$, genau dann, wenn $U_{CE}$ zu steigen beginnt, nachgewiesen werden. Zu dem gleichen Zeitpunkt wird die Basis-Emitter-Spannung fast 0 Volt (Kreis in Fig. 2b). Beide Maßnahmen zusammen, d.h. Ladungsträgerabfluß aus der Basis des Haupttransistors T1 sowie Klemmung der Basis-Emitter-Spannung $U_{BE}$ des Haupttransistors T1 nahe 0 Volt führt zu einer deutlichen Beschleunigung des Abschaltvorgangs. Im Vergleich zum Abschaltvorgang von Fig. 1b ist der Kurvenverlauf des Kollektorstroms $I_C$ nunmehr konkav. Der Strom $I_C$ ist bereits auf akzeptable Werte zurückgegangen, solange die Kollektor-Emitter-Spannung $U_{CE}$ noch niedrig ist. Das Verhältnis aus der Fläche A' zur Fläche B' ist wesentlich geringer geworden, was auf deutlich geringere Verluste während des Abschaltvorgangs hinweist.

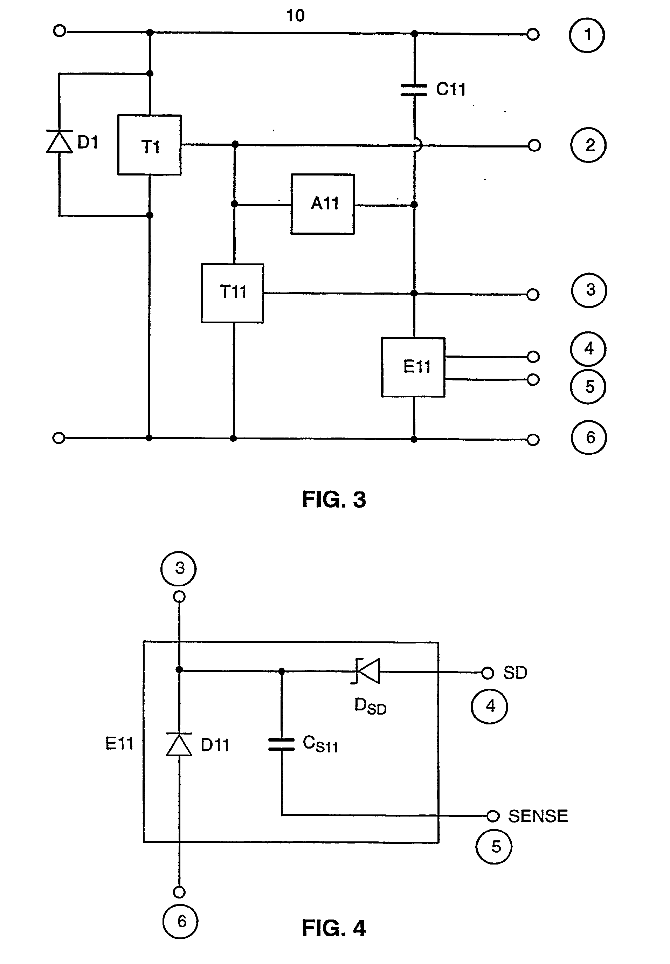

Fig. 3 zeigt ein Prinzipschaltbild einer erfindungsgemäßen Schaltungsanordnung 10. Von den rechts im Bild angegebenen Anschlüssen bezeichnet Anschluß 1 die Arbeitselektrode des Hauptschalters T1, Anschluß 2 die Steuerelektrode des Hauptschalters T1 bzw. die Arbeitselektrode des Hilfsschalters T11, Anschluß 3 die Steuerelektrode des Hilfsschalters T11, Anschluß 4 einen SHUT-DOWN-Eingangsanschluß der Entladeeinheit E11, Anschluß 5 einen SENSE-Ausgangsanschluß der Entladeeinheit E11 und Anschluß 6 die Bezugselektrode sowohl für den Hauptschalter T1 als auch für den Hilfsschalter T11. Antiparallel zum Hauptschalter T1 ist eine Freilauf diode D1 geschaltet. Der Mitkoppelkondensator C11 ist, wie bereits erwähnt, zwischen Arbeitselektrode des Hauptschalters T1 und Steuerelektrode des Hilfsschalters T11 angeordnet. Die Entladeeinheit E11 ist zwischen der Steuerelektrode des Hilfsschalters T11 und der Bezugselektrode beider Schalter angeordnet. Zwischen der Steuerelektrode des Hauptschalters bzw. der Arbeitselektrode des Hilfsschalters und der Steuerelektrode des Hilfsschalters kann eine Antisättigungsschaltung A11 vorgesehen sein, die weiter unten näher beschrieben wird.

Der Hauptschalter T1 kann als Bipolartransistor realisiert sein, die Kombination aus Hauptschalter T1 und Freilaufdiode D1 kann auch durch einen MOSFET realisiert sein, wobei die Bodydiode des MOSFET die Funktion der Freilaufdiode D1 übernimmt.

Der Hilfsschalter T11 kann ein Bipolartransistor sein, ein Bipolartransistor mit Seriendiode im Kollektor, ein MOSFET oder ein MOSFET mit Seriendiode in der Drain, wobei bei Verwendung einer Seriendiode deren Orientierung so erfolgt, daß ein Stromfluß in der Hauptstromflußrichtung des Hilfsschalters T11 ermöglicht wird. Diese Seriendiode kann eine pn-Diode oder vorzugweise eine Schottky-Diode sein. Eine einfache Ausführungsform der Entladeeinheit E11 wurde bereits im Zusammenhang mit Fig. 2a vorgestellt. Sie kann als Schottky-Diode, Zenerdiode oder pn-Diode realisiert sein. Ihre Funktion besteht darin, eine Entladung des Kondensators C11 zu ermöglichen, bevor der Hauptschalter T1 das nächste Mal ausgeschaltet wird.

Fig. 4 zeigt eine weitere Ausführungsform der Entladeeinheit E11. Bei dieser Ausführungsform ist ein SHUT-DOWN-Eingangsanschluß SD über eine Diode $D_{SD}$ mit dem an die Steuerelektrode des Hilfsschalters T11 anzuschließenden Ausgang der Entladeeinheit verbunden. Die SHUT-DOWN-Diode $D_{SD}$ kann als pn- oder Schottky-Diode realisiert sein. Über den SHUT-DOWN-Eingang SD kann der Hilfsschalter T11 von außen eingeschaltet werden. Dadurch wird die Ansteuerung des Hauptschalters T1 kurzgeschlossen. Dies ermöglicht, den SHUT-DOWN-Eingang zur Sicherheitsabschaltung, beispielsweise falls ein Bauelement der Schaltung in die Sättigung gerät oder die Schaltung zu heiß wird, zu verwenden. Die Diode $D_{SD}$ verhindert, daß die Mitkoppelfunktion des Mitkoppelkondensators C11 durch den SHUT-DOWN-Eingangsanschluß SD abgeschwächt würde, wie dies der Fall wäre, wenn Ladungsträger nicht wie beabsichtigt auf die Steuerelektrode des Hilfsschalters T11, sondern aus dem SHUT-DOWN-Eingangsanschluß herausfließen würden.

Die Entladeeinheit E11 gemäß Fig. 4 verfügt weiterhin über einen SENSE-Ausgangsanschluß, mit dem der Status der Entladeeinheit und damit der Schaltstatus des Haupt- und/oder Hilfsschalters abgefragt werden kann. Ein Kondensator $C_{S11}$ kann vorgesehen werden, um das Potential des SENSE-Ausgangsanschlusses auf das gewünschte Niveau zu verschieben. Der SENSE-Ausgangsanschluß kann insbesondere beim Soft-Switching und bei fremdgesteuerten Halbbrücken vorteilhaft eingesetzt werden.

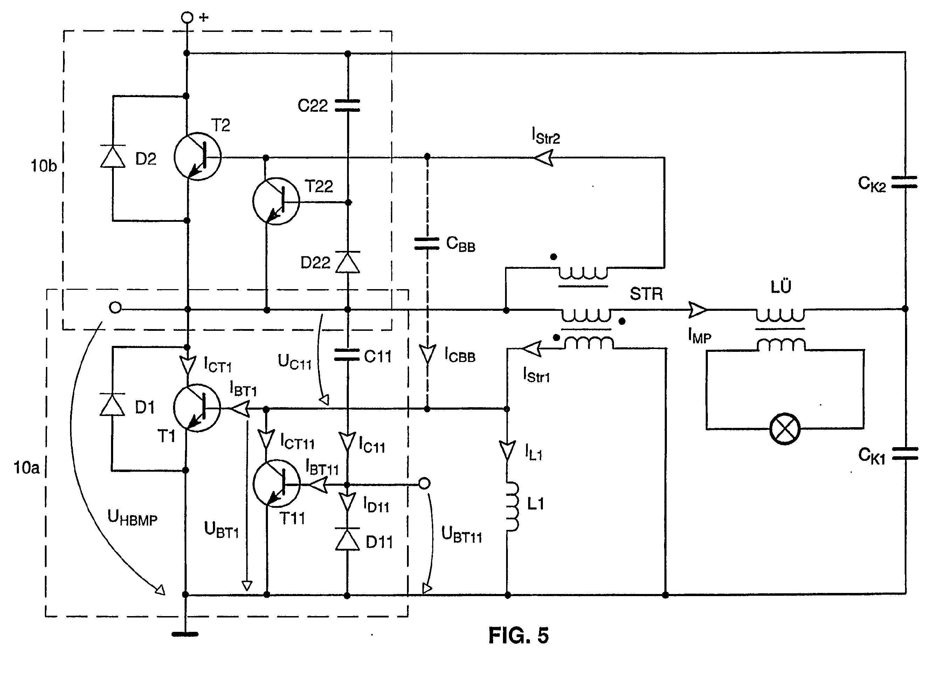

Die erfindungsgemäße Schaltungsanordnung ist in vielerlei Schaltungen einsetzbar, beispielsweise in Tiefsetzstellern, Hochsetzstellern, Drossel-InversWandlern, Leistungs-Faktor-Korrekturschaltungen, 'Cuk-Konvertern, etc., insbesondere auch in Betriebsgeräten für elektrische Lampen. Beispielhaft ist in Fig. 5 die Anwendung zweier erfindungsgemäßer Schaltungsanordnungen in einem selbstgesteuerten, d.h. freischwingenden Wechselrichter zum Betreiben einer Niedervolt-Halogenglühlampe dargestellt. Der Wechselrichter umfaßt eine erste und eine zweite erfindungsgemäße Schaltungsanordnung 10a und 10b. Jede dieser Schaltungsanordnungen umfaßt einen Hauptschalter T1, T2, einen Hilfsschalter T11, T22, eine Freilaufdiode D1, D2, eine Entladediode D11, D22, einen Mitkoppelkondensator C11, C22. Zwischen den Steuerelektroden der beiden Hauptschalter T1, T2 ist ein sogenannter Basisbrückenkondensator $C_{BB}$ (gestrichelt eingezeichnet und optional) geschaltet, der dazu dient, den möglicherweise zu früh einsetzenden Strom zur Basisaufsteuerung bzw. Transistoreinschaltung sozusagen "abzusaugen". Detaillierte Ausführungen zum Basisbrückenkondensator können der DE 197 28 295 A1 (desselben Erfinders wie der vorliegenden Erfindung) entnommen werden. Die beiden Hilfstransistoren T11 und T12 haben den weiteren Vorteil, daß sie die prinzipbedingt ausschaltverlangsamende Wirkung des Basisbrückenkondensators aufheben. Zur Ansteuerung der beiden Hauptschalter dient ein Steuertransformator STR, dessen Primärwicklung vom Strom $I_{MP}$ durchflossen wird und dessen Sekundärwicklungen mit den Steuereingängen der beiden Hauptschalter T1 und T2 verbunden sind. Die Last wird vorliegend von einer durch einen Übertrager angekoppelten Lampe gebildet, wobei die vom Strom $I_{MP}$ durchflossene Wicklung des Übertragers zum einen mit der Primärwicklung des Steuertransformators STR, zum andern mit zwei Koppelkondensatoren $C_{K1}$ und $C_{K2}$ verbunden ist. Der Koppelkondensator $C_{K2}$ ist mit der Arbeitselektrode des Transistors T2, der Koppelkondensator $C_{K1}$ mit der Bezugselektrode des Transistors T1 verbunden. Die Funktion der Stabkerndrossel L ist für das Verständnis der vorliegenden Erfindung ohne Bedeutung; nähere Ausführungen hierzu können der DE 44 36 465 A1 entnommen werden.

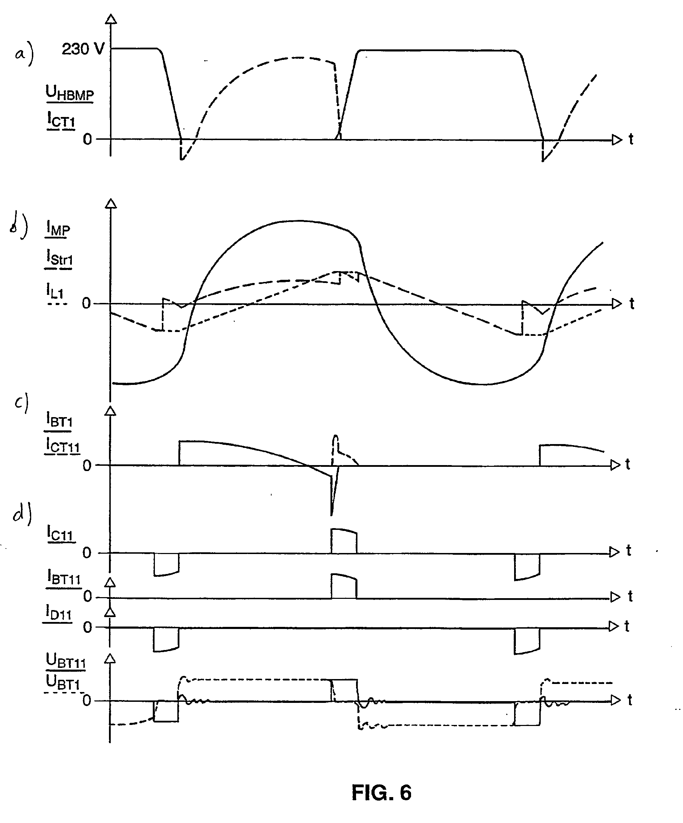

Um die Funktion der Erfindung mit Bezug auf die Fig. 6 näher zu erläutern, werden die folgenden Größen eingeführt: $U_{HBMP}$ bezeichnet die Spannung am Halbbrückenmittelpunkt. Aufgrund des geringen Spannungsabfalls an der Entladediode D11 ist $U_{HBMP}$ in etwa gleich der Spannung $U_{C11}$, auf die der Mitkoppelkondensator C11 aufgeladen ist. Am Pluspol der Schaltung liegt eine Spannung von 230 $V_{DC}$. Aufgrund des im Ausführungsbeispiel höchstmöglichen Werts von 230 V für $U_{HBMP}$ und der Niederohmigkeit der abwechselnd eingeschalteten Hauptschalter-Transistoren T1 und T2 ist $U_{HBMP}$ die erste Leitgröße für die folgende Betrachtung.

Die zweite Leitgröße ist der Strom $I_{MP}$ durch die Primärwicklung des Leistungsübertragers LÜ. Diese Größe $I_{MP}$ hat aufgrund ihrer großen Amplitude und aufgrund von $W = (L/2)*I^2$ den größten Wechselenergiegehalt in der Anordnung von Fig. 5. Alle anderen Ströme in dieser Anordnung außer $I_{L1}$ sind direkt oder indirekt von $I_{MP}$ abhängig. Die Spannungen über $C_{K1}$ und $C_{K2}$ ergeben in Summe 230 V und stellen sich so ein, daß $I_{MP}$ ein reiner Wechselstrom ist. Leitet der Hauptschalter T1 in positiver Richtung, so gilt $I_{CT1} = I_{MP}$.

Unter der Annahme, daß die Magnetisierungsinduktivität des Ansteuerübertragers STR bei vorliegenden Schaltfrequenzen unwirksam ist, wird genau der Bruchteil des Hauptstroms $I_{MP}$, wie er durch das Windungsverhältnis des Steuertransformators STR festgelegt ist, auf dessen "untere Sekundärwicklung" als Strom $I_{STR1}$ übertragen, solange der Hauptschalter T1 leitfähig ist. Der Windungssinn im Steuertransformator STR ergibt erstens die Strom-Mitkopplung und zweitens den Gegentaktbetrieb, d.h. das abwechselnde Einschalten von T1 und T2. Daraus folgt, daß dann, wenn T2 eingeschaltet werden soll, der gleiche Bruchteil von $I_{MP}$ wie soeben beschrieben als $I_{Str2}$ auf die "obere Sekundärwicklung" übertragen wird.

Der Beitrag, den $I_{Str1}$ zur Ansteuerung von T1 leistet, wird reduziert um den jeweiligen Wert von $I_{L1}$, der in der Umschwingspule L1 fließt. Solange $I_{CT11} = 0$ ist und solange $U_{HBMP}$ abschnittsweise konstant ist, gilt

$$I_{BT1} = I_{Str1} - I_{L1}.$$

In den anderen Phasen, also während der Umschaltvorgänge, d.h. während $U_{HBMP}$ sich zeitlich verändert, wird der Ansteuerstrom $I_{BT1}$ für den Hauptschalter T1 um den Hilfsschalter-Kollektorstrom $I_{CT11}$ reduziert und um den Basisbrückenkondensatorstrom $I_{CBB}$ erhöht. Es gilt dann:

$$I_{BT1} = I_{Str1} - I_{L1} + I_{CBB} - I_{CT11}.$$

Da die Umschwingspule L1 direkt parallel zur Basis-Emitter-Strecke des Hauptschalters T1 geschaltet ist, ist die dritte unabhängige Größe $I_{L1}$ einzig von der Induktivität der Umschwingspule L1 und von der Hauptschalter-Steuerspannung $U_{BT1}$ bestimmt. Solange T1 angesteuert wird, also $U_{BT1}$ positiv ist, steigt $I_{L1}$ rampenförmig an. Solange T2 angesteuert wird, ist durch den Windungssinn im Ansteuerübertrager STR die Steuerspannung des oberen Hauptschalters auf der unteren Seite invers zu sehen, $U_{BT1}$ ist negativ, und $I_{L1}$ nimmt rampenförmig ab. Daraus ergibt sich der dreiecksförmige Verlauf von $I_{L1}$.

Im Gegensatz zur DE 44 36 465 A1 ist die Umschwingspule L1 hier direkt mit Masse verbunden. Die wesentliche Funktion dieses Bauteils bleibt davon unbeeinflußt.

Ändert sich $U_{HBMP}$ zeitlich, wird auch $U_{C11}$ entsprechend geändert. Aufgrund des Kondensators C11 ergibt sich dabei der Ladestrom $I_{C11}$, der bei gemäß Zählrichtung positiven Werten als $I_{BT11}$ durch die Basis des Hilfsschalters T11 fließt und diesen einschaltet, der bei negativen Werten als Ion durch die Entladediode D11 fließt.

Die Spannung der Basis des Transistors T11 gegenüber dem Bezugspotential, also die Ansteuerspannung für den Hilfsschalter T11, ist $U_{BT11}$. Mit Bezug auf Fig. 6 verhält sich der zeitliche Verlauf der soeben eingeführten Größen wie folgt:

Fig. 6a zeigt zunächst den fortlaufenden Wechsel der Spannung $U_{HBMP}$ zwischen Masse und angelegter Gleichspannung. Zu beachten ist, daß die Flanken des Spannungsverlaufs von $U_{HBMP}$ eine endliche, von Null verschiedene Anstiegs- bzw. Abfallzeit haben.

Fig. 6b zeigt den Stromverlauf $I_{MP}$, der um den Nullpunkt schwankend einmal positiv und einmal negativ ist. Aufgrund ihrer Verkopplung im Steuertransformator STR korrespondiert der Strom $I_{Str1}$ mit dem Verlauf des Stroms $I_{MP}$. Der Strom $I_{L1}$ verläuft im wesentlichen nahezu dreiecksförmig. Mit

$$I_{BT1} = I_{Str1} - I_{L1}$$

folgt, daß $I_{BT1}$ negativ wird, sobald $I_{L1} > I_{Str1}$ gilt. In diesen Zeiten wird die Basis des Transistors T1 aktiv ausgeräumt und daher ein schneller Ausschaltvorgang des Transistors T1 vorbereitet.

Der in Fig. 6c dargestellte Verlauf des Stroms $I_{C11}$ durch den Kondensator C11 setzt sich zusammen aus positiven Impulsen und negativen Impulsen. Die positiven Impulse treten auf während der Anstiegsflanken der Spannung $U_{HBMP}$ und werden als Strom $I_{BT11}$ auf die Basis des Hilfstransistors T11 geleitet. Nach einem derartigen positiven Impuls befindet sich der Mitkoppelkondensator C11 im geladenen Zustand. Die negativen Impulse rühren her von der während des Übergangs des Transistors T1 vom AUS- in den EIN-Zustand abnehmenden Spannung $U_{HBMP}$, wovon der durch die Diode D11 auf den Kondensator C11 fließende Entladestrom herrührt. Hierdurch wird der Kondensator C11 entladen und steht für eine Mitkoppelung während des nächsten Einschaltvorgangs des Transistors T1 wieder zur Verfügung.

Fig. 6d zeigt den Verlauf der Spannung $U_{BT11}$, die der Basis-Emitter-Spannung am Transistor T11 entspricht. Die positiven Impulse entsprechen der Basis-Emitter-Spannung von Transistor T11 in dessen EIN-Zustand, während die negativen Impulse der an der Diode D11 in deren leitendem Zustand abfallenden Spannung entsprechen.

**Patentansprüche**

1. Schaltungsanordnung mit
   mindestens einem elektrischen Hauptschalter (T1; T2) mit einer Bezugselektrode (E), einer Steuerelektrode (B) und einer Arbeitselektrode (C),
   einer Freilaufdiode (D1; D2), die zur Hauptstromflußrichtung des mindestens einen elektrischen Hauptschalters (T1; T2) antiparallel geschaltet ist,
   **dadurch gekennzeichnet,**
   **daß** einem jedem Hauptschalter (T1; T2) ein elektrischer Hilfsschalter (T11; T22) zugeordnet ist, dessen Arbeitselektrode mit der Steuerelektrode (B) des zugehörigen Hauptschalters (T1; T2) und dessen Bezugselektrode mit der Bezugselektrode (E) des zugehörigen Hauptschalters (T1; T2) verbunden ist, wobei zwischen der Steuerelektrode des Hilfsschalters (T11; T22) und der Arbeitselektrode (C) des zugehörigen Hauptschalters (T1; T2) mindestens ein Kondensator (C11; C22) angeordnet ist, und wobei zwischen der Steuerelektrode und der Bezugselektrode des Hilfsschalters eine Entladeeinheit (E11; D11; D22) derart angeordnet ist, daß der mindestens ein Kondensator (C11; C22) während des Übergangs des Hauptschalters (T1; T2) vom AUS- in den EIN-Zustand entladen werden kann.

2. Schaltungsanordnung nach Anspruch 1, **dadurch**

gekennzeichnet, daß die Entladeeinheit einen Shut-Down-Eingangsanschluß (SD) aufweist, über den ein den Hilfsschalter (T11) in den EIN-Zustand schaltendes Signal anlegbar ist.

3. Schaltungsanordnung nach Anspruch 1 oder 2, **dadurch gekennzeichnet, daß** die Entladeeinheit (E11) einen Widerstand umfaßt.

4. Schaltungsanordnung nach Anspruch 1 oder 2, **dadurch gekennzeichnet, daß** die Entladeeinheit (E11) eine Entladediode (D11; D22) umfaßt.

5. Schaltungsanordnung nach Anspruch 4, **dadurch gekennzeichnet, daß** der Entladediode (D11; D22) mindestens ein Widerstand seriell und/oder parallel geschaltet ist.

6. Schaltungsanordnung nach Anspruch 4 oder 5, **dadurch gekennzeichnet, daß** die Entladediode (D11; D22) eine Schottky-Diode, eine Zenerdiode oder eine pn-Diode ist.

7. Schaltungsanordnung nach einem der Ansprüche 2 bis 6, **dadurch gekennzeichnet, daß** der Shut-Down-Eingangsanschluß (SD) mit der Steuerelektrode des Hilfsschalters (T11) verbunden ist, wobei zwischen Shut-Down-Eingangsanschluß (SD) und Steuerelektrode des Hilfsschalters (T11) eine Shut-Down-Diode ($D_{SD}$) angeordnet ist, deren Kathode mit dem Anschluß der Steuerelektrode des Hilfsschalters verbunden ist.

8. Schaltungsanordnung nach Anspruch 7, **dadurch gekennzeichnet, daß** die Shut-Down-Diode ($D_{SD}$) eine pn- oder Schottky-Diode ist.

9. Schaltungsanordnung nach Anspruch 1, **dadurch gekennzeichnet, daß** die Entladeeinheit (E11) einen Sense-Ausgangsanschluß aufweist, der mit der Steuerelektrode des Hilfsschalters (T11) verbunden ist, so daß über den Sense-Ausgangsanschluß der Schaltstatus des Haupt- und/oder Hilfsschalters abfragbar ist.

10. Schaltungsanordnung nach Anspruch 9, **dadurch gekennzeichnet, daß** zwischen dem Sense-Ausgangsanschluß und der Steuerelektrode des Hilfsschalters (T11) mindestens ein Kondensator ($C_{S11}$) angeordnet ist.

11. Schaltungsanordnung nach einem der vorhergehenden Ansprüche, **dadurch gekennzeichnet, daß** sie weiterhin eine Antisättigungseinheit (A11) aufweist, die zwischen Arbeitselektrode und Steuerelektrode des Hilfsschalters (T11) angeordnet ist und eine Sättigung der Steuerelektrode des Hilfsschalters (T11) verhindert.

12. Schaltungsanordnung nach "Anspruch 11, **dadurch gekennzeichnet, daß** die Antisättigungseinheit (A11) einen Antisättigungswiderstand aufweist, der so angeordnet ist, daß im Falle der Sättigung der Steuerelektrode des Hilfsschalters (T11) Ladungsträger zur Arbeitselektrode des Hilfsschalters abfließen können.

13. Schaltungsanordnung nach Anspruch 11, **dadurch gekennzeichnet, daß** die Antisättigungseinheit (A11) eine Antisättigungsdiode aufweist, die derart angeordnet ist, daß im Falle der Sättigung der Steuerelektrode des Hilfsschalters (T11) Ladungsträger zur Arbeitselektrode des Hilfsschalters abfließen können.

14. Schaltungsanordnung nach Anspruch 13, **dadurch gekennzeichnet, daß** die Antisättigungsdiode eine pn- oder Schottky-Diode ist.

15. Schaltungsanordnung nach Anspruch 13 oder 14, **dadurch gekennzeichnet, daß** seriell und/oder parallel zur Antisättigungsdiode mindestens ein Widerstand geschaltet ist.

16. Schaltungsanordnung nach einem der vorhergehenden Ansprüche, **dadurch gekennzeichnet, daß** ein Hauptschalter (T1; T2) ein Bipolartransistor ist.

17. Schaltungsanordnung nach einem der vorhergehenden Ansprüche, **dadurch gekennzeichnet, daß** ein Hauptschalter (T1; T2) zusammen mit der zugehörigen Freilaufdiode (D1; D2) durch einen MOSFET realisiert ist.

18. Schaltungsanordnung nach einem der vorhergehenden Ansprüche, **dadurch gekennzeichnet, daß** ein Hilfsschalter (T11; T22) ein Bipolartransistor, ein Bipolartransistor mit Seriendiode im Kollektor, ein MOSFET oder ein MOSFET mit Seriendiode in der Drain ist, wobei bei Verwendung einer Seriendiode deren Orientierung so erfolgt, daß ein Stromfluß in der Hauptstromflußrichtung des zugehörigen Hilfsschalters (T11; T22) ermöglicht wird.

19. Schaltungsanordnung nach Anspruch 18, **dadurch gekennzeichnet, daß** die Seriendiode des Hilfsschalters (T11; T22) eine pn- oder eine Schottky-Diode ist.

20. Brückenschaltung mit mindestens einer ersten und einer zweiten Schaltungsanordnung (10a, 10b) nach einem der vorhergehenden Ansprüche, **dadurch gekennzeichnet, daß** von der ersten und der zweiten Schaltungsanordnung (10a, 10b) eine Brücke dadurch gebildet ist, daß die Bezugselektrode des Hauptschalters (T2) der zweiten Schaltungsanordnung (10b) mit der Arbeitselektrode des Hauptschalters (T1) der ersten Schaltungsanordnung (10a) verbunden ist.

21. Freischwingende Oszillatorschaltung zum Betreiben einer Last mit einer Brückenschaltung nach Anspruch 20, **dadurch gekennzeichnet, daß** sie eine Schaltsteuereinrichtung (STR) zur rückkoppelnden Übertragung des Laststroms ($I_{MP}$) auf die Steuerelektroden der Hauptschalter (T2, T1) der ersten und zweiten Schaltungsanordnung (10b, 10a) aufweist, wobei die Steuerelektrode jedes Hauptschalters (T1; T2) mit der Schaltsteuereinrichtung (STR) durch jeweils eine Anschlußleitung verbunden ist und die beiden Anschlußleitungen ihrerseits über mindestens einen Basisbrückenkondensator ($C_{BB}$) miteinander verbunden sind.

22. Schaltung nach Anspruch 21, **dadurch gekennzeichnet, daß** die Schaltsteuereinrichtung ein Steuertransformator (STR) ist.

23. Schaltung nach Anspruch 21 oder 22, **dadurch gekennzeichnet, daß** der Basisbrückenkondensator ($C_{BB}$) jeweils direkt an der Steuerelektrode jedes Hauptschalters (T1; T2) und/oder jeweils direkt an dem der Steuerelektrode des jeweiligen Hauptschalters (T1; T2) zugewandten Ausgang der Schaltsteuereinrichtung (STR) angeschlossen ist.

**Claims**

1. Circuit arrangement comprising
at least one electrical main switch (T1;T2) having a reference electrode (E), a control electrode (B) and an operating electrode (C),
a freewheeling diode (D1;D2), which is connected in antiparallel fashion with the main current-flow direction of the at least one electrical main switch (T1;T2), **characterized in that**
assigned to each main switch (T1;T2) is an electrical auxiliary switch (T11;T22), the operating electrode of which is connected to the control electrode (B) of the associated main switch (T1;T2), and the reference electrode of which is connected to the reference electrode (E) of the associated main switch (T1; T2), where at least one capacitor (C11;C22) is arranged between the control electrode of the auxiliary switch (T11;T22) and the operating electrode (C) of the associated main switch (T1;T2), and
where a discharge unit (E11;D11;D22) is arranged between the control electrode and the reference electrode of the auxiliary switch in such a way that the at least one capacitor (C11;C22) can be discharged during the transition of the main switch (T1; T2) from the OFF state to the ON state.

2. Circuit arrangement according to Claim 1, **characterized in that** the discharge unit comprises a shutdown input terminal (SD), via which a signal can be applied that switches the auxiliary switch (T11) into the ON state.

3. Circuit arrangement according to Claim 1 or 2, **characterized in that** the discharge unit (E11) comprises a resistor.

4. Circuit arrangement according to Claim 1 or 2, **characterized in that** the discharge unit (E11) comprises a discharge diode (D11;D22).

5. Circuit arrangement according to Claim 4, **characterized in that** at least one resistor is connected in series and/or parallel with the discharge diode (D11; D22).

6. Circuit arrangement according to Claim 4 or 5, **characterized in that** the discharge diode (D11;D22) is a Schottky diode, a Zener diode or a pn diode.

7. Circuit arrangement according to any of Claims 2 to 6, **characterized in that** the shutdown input terminal (SD) is connected to the control electrode of the auxiliary switch (T11), where a shutdown diode ($D_{SD}$) is arranged between shutdown input terminal (SD) and control electrode of the auxiliary switch (T11), the cathode of which shutdown diode is connected to the terminal of the control electrode of the auxiliary switch.

8. Circuit arrangement according to Claim 7, **characterized in that** the shutdown diode ($D_{SD}$) is a pn diode or Schottky diode.

9. Circuit arrangement according to Claim 1, **characterized in that** the discharge unit (E11) has a sense output terminal, which is connected to the control electrode of the auxiliary switch (T11), so that the switching status of the main switch and/or auxiliary switch can be retrieved via the sense output terminal.

10. Circuit arrangement according to Claim 9, **characterized in that** at least one capacitor ($C_{S11}$) is arranged between the sense output terminal and the control electrode of the auxiliary switch (T11).

11. Circuit arrangement according to any of the previous claims, **characterized in that** it also comprises an anti-saturation unit (A11), which is arranged between operating electrode and control electrode of the auxiliary switch (T11) and prevents saturation of the control electrode of the auxiliary switch (T11).

12. Circuit arrangement according to Claim 11, **characterized in that** the anti-saturation unit (A11) has an anti-saturation resistor, which is arranged so that, in the event of saturation of the control electrode of the auxiliary switch (T11), charge carriers can flow out to the operating electrode of the auxiliary switch.

13. Circuit arrangement according to Claim 11, **characterized in that** the anti-saturation unit (A11) has an anti-saturation diode, which is arranged so that, in the event of saturation of the control electrode of the auxiliary switch (T11), charge carriers can flow out to the operating electrode of the auxiliary switch.

14. Circuit arrangement according to Claim 13, **characterized in that** the anti-saturation diode is a pn diode or Schottky diode.

15. Circuit arrangement according to Claim 13 or 14, **characterized in that** at least one resistor is connected in series and/or parallel with the anti-saturation diode.

16. Circuit arrangement according to any of the previous claims, **characterized in that** a main switch (T1;T2) is a bipolar transistor.

17. Circuit arrangement according to any of the previous claims, **characterized in that** a main switch (T1;T2) together with the associated freewheeling diode (D1; D2) is implemented by a MOSFET.

18. Circuit arrangement according to any of the previous claims, **characterized in that** an auxiliary switch (T11;T22) is a bipolar transistor, a bipolar transistor having a series diode in the collector, a MOSFET or a MOSFET having a series diode in the drain, where, if a series diode is used, it is oriented so that a current is able to flow in the main current-flow direction of the associated auxiliary switch (T11;T22).

19. Circuit arrangement according to Claim 18, **characterized in that** the series diode of the auxiliary switch (T11;T22) is a pn diode or a Schottky diode.

20. Bridge circuit having at least a first and a second circuit arrangement (10a,10b) according to any of the previous claims, **characterized in that** a bridge is formed from the first and the second circuit arrangement (10a,10b) by the reference electrode of the main switch (T2) of the second circuit arrangement (10b) being connected to the operating electrode of the main switch (T1) of the first circuit arrangement (10a).

21. Free-running oscillator circuit for operating a load having a bridge circuit according to Claim 20, **characterized in that** it has a switching control device (STR) for feeding back the load current ($I_{MP}$) to the control electrodes of the main switches (T2,T1) of the first and second circuit arrangement (10b,10a), where the control electrode of each main switch (T1; T2) is connected to the switching control device (STR) by a respective connecting line, and the two connecting lines are themselves connected to one another via at least one base bridge capacitor ($C_{BB}$) .

22. Circuit according to Claim 21, **characterized in that** the switching control device is a control transformer (STR).

23. Circuit according to Claim 21 or 22, **characterized in that** the base bridge capacitor ($C_{BB}$) is connected directly to the respective control electrode of each main switch (T1;T2) and/or directly to the respective output of the switching control device (STR) facing the control electrode of the respective main switch (T1; T2) .

## Revendications

1. Circuit comprenant au moins un commutateur principal électrique ( T1 ; T2 ) ayant une électrode de référence ( E ), une électrode de commande ( B ) et une électrode de travail( C ) et une diode de roue libre ( D1 ; D2 ) qui est branchée selon un montage antiparallèle par rapport au sens de courant principal de l'au moins un commutateur principal électrique ( T1 ; T2 ),

   **caractérisé par le fait qu'**il est associé à chaque commutateur principal ( T1 ; T2 ) un commutateur auxiliaire électrique ( T11 ; T22 ) dont l'électrode de travail est reliée à l'électrode de commande ( B ) du commutateur principal associé ( T1 ; T2 ) et dont l'électrode de référence est reliée à l'électrode de référence ( E ) du commutateur principal associé ( T1 ; T2 ), au moins un condensateur ( C11 ; C22 ) étant entre l'électrode de commande du commutateur auxiliaire ( T11 ; T22 ) et l'électrode de travail ( C ) du commutateur principal associé ( T1 ; T2 ) et une unité de décharge ( E11 ; D11 ; D22 ) étant montée de telle sorte entre l'électrode de commande et l'électrode de référence du commutateur auxiliaire que l'au moins un condensateur ( C11 ; C22 ) peut être déchargé pendant la transition du commutateur principal ( T1 ; T2 ) de l'état déconnecté à l'état connecté.

2. Circuit selon la revendication 1, **caractérisé par le fait que** l'unité de décharge comporte une borne d'entrée d'arrêt ( Shut Down, SD ) par l'intermédiaire de laquelle un signal commutant le commutateur auxiliaire ( T11 ) dans l'état connecté peut être appliqué.

3. Circuit selon la revendication 1 ou 2, **caractérisé par le fait que** l'unité de décharge ( D11 ) comprend

**4.** Circuit selon la revendication 1 ou 2, **caractérisé par le fait que** l'unité de décharge ( E11 ) comprend une diode de décharge ( D11 ; D22 ).

**5.** Circuit selon la revendication 4, **caractérisé par le fait qu'**au moins une résistance est montée en série et/ou en parallèle avec la diode de décharge ( D11 ; D22 ).

**6.** Circuit selon la revendication 4 ou 5, **caractérisé par le fait que** la diode de décharge ( D11 ; D22 ) est une diode de Schottky, une diode Zener ou une diode pn.

**7.** Circuit selon l'une des revendications 2 à 6, **caractérisé par le fait que** la borne d'entrée d'arrêt ( SD ) est reliée à l'électrode de commande du commutateur auxiliaire ( T11 ), une diode d'arrêt ( DSD ) dont la cathode est reliée à la borne de l'électrode de commande du commutateur auxiliaire étant montée entre la borne d'entrée d'arrêt ( SD ) et l'électrode de commande du commutateur auxiliaire ( T11 ).

**8.** Circuit selon la revendication 7, **caractérisé par le fait que** la diode d'arrêt ( DSD ) est une diode pn ou une diode de Schottky.

**9.** Circuit selon la revendication 1, **caractérisé par le fait que** l'unité de décharge ( E11 ) comporte une borne de sortie de lecture qui est reliée à l'électrode de commande du commutateur auxiliaire ( T11 ) de telle sorte que l'état de commutation du commutateur principal et/ou du commutateur auxiliaire peut être connu par l'intermédiaire de la borne de sortie de lecture.

**10.** Circuit selon la revendication 9, **caractérisé par le fait qu'**au moins un condensateur ( CS11 ) est monté entre la borne de sortie de lecture et l'électrode de commande du commutateur auxiliaire ( T11 ).

**11.** Circuit selon l'une des revendications précédentes, **caractérisé par le fait qu'**il comporte aussi une unité d'anti-saturation ( A11 ) qui est montée entre l'électrode de travail et l'électrode de commande du commutateur auxiliaire ( T11 ) et qui empêche une saturation de l'électrode de commande du commutateur auxiliaire ( T11 ).

**12.** Circuit selon la revendication 11, **caractérisé par le fait que** l'unité d'anti-saturation ( A11 ) comporte une résistance d'anti-saturation qui est montée de telle sorte que, en cas de saturation de l'électrode de commande du commutateur auxiliaire ( T11 ), des porteurs de charge peuvent passer vers l'électrode de travail du commutateur auxiliaire.

**13.** Circuit selon la revendication 11, **caractérisé par le fait que** l'unité d'anti-saturation ( A11 ) comporte une diode d'anti-saturation qui est montée de telle sorte que, en cas de saturation de l'électrode de commande du commutateur auxiliaire ( T11 ), des porteurs de charge peuvent passer vers l'électrode de travail du commutateur auxiliaire.

**14.** Circuit selon la revendication 13, **caractérisé par le fait que** la diode d'anti-saturation est une diode pn ou une diode de Schottky.

**15.** Circuit selon la revendication 13 ou 14, **caractérisé par le fait qu'**au moins une résistance est montée en série et/ou en parallèle avec la diode d'anti-saturation.

**16.** Circuit selon l'une des revendications précédentes, **caractérisé par le fait qu'**un commutateur principal ( T1 ; T2 ) est un transistor bipolaire.

**17.** Circuit selon l'une des revendications précédentes, **caractérisé par le fait qu'**un commutateur principal ( T1 ; T2 ) est réalisé conjointement avec la diode de roue libre associée ( D1 ; D2 ) par un MOSFET.

**18.** Circuit selon l'une des revendications précédentes, **caractérisé par le fait qu'**un commutateur auxiliaire ( T11 ; T22 ) est un transistor bipolaire, un transistor bipolaire avec diode série dans le collecteur, un MOSFET ou un MOSFET avec diode série dans le drain sachant que, dans le cas de l'utilisation d'une diode série, l'orientation de celle-ci s'effectue de telle sorte qu'un flux de courant est possible dans le sens de courant principal du commutateur auxiliaire associé ( T11 ; T22 ).

**19.** Circuit selon la revendication 18, **caractérisé par le fait que** la diode série du commutateur auxiliaire ( T11 ; T22 ) est une diode pn ou une diode de Schottky.

**20.** Circuit à pont avec au moins un premier et un deuxième circuit ( 10a, 10b ) selon l'une des revendications précédentes, **caractérisé par le fait qu'**un pont est formé par le premier et le deuxième circuit ( 10a, 10b ) **par le fait que** l'électrode de référence du commutateur principal ( T2 ) du deuxième circuit ( 10b ) est reliée à l'électrode de travail du commutateur principal ( T1 ) du premier circuit ( 10a ).

**21.** Circuit oscillateur auto-oscillant pour faire fonctionner une charge avec un circuit à pont selon la revendication 20, **caractérisé par le fait qu'**il comporte un dispositif de commande de commutation ( STR ) pour la transmission avec rétroaction du courant de charge ( $I_{MP}$ ) sur les électrodes de commande des commutateurs principaux ( T2, T1 ) du premier et du deuxième circuit ( 10b, 10a ), l'électrode de commande de chaque commutateur principal ( T1 ; T2 ) étant reliée au dispositif de commande de commutation ( STR ) à chaque fois par l'intermédiaire d'une ligne de raccordement et les deux lignes de raccordement étant quant à elles reliées entre elles par l'intermédiaire d'au moins un condensateur de pont de base ( $C_{BB}$ ) .

22. Circuit selon la revendication 21, **caractérisé par le fait que** le dispositif de commande de commutation est un transformateur de commande ( STR ).

23. Circuit selon la revendication 21 ou 22, **caractérisé par le fait que** le condensateur de pont de base ( $C_{BB}$ ) est raccordé respectivement directement à l'électrode de commande de chaque commutateur principal ( T1 ; T2 ) et/ou respectivement directement à celle des sorties du dispositif de commande de commutation ( STR ) qui est proche de l'électrode de commande du commutateur principal respectif ( T1 ; T2 ) .

## FIG. 1a

## FIG. 1b

**FIG. 2a**

**FIG. 2b**

10

① ② ③ ④ ⑤ ⑥

D1 T1 C11 A11 T11 E11

**FIG. 3**

③

E11 D11 C_{S11} D_{SD} SD ④ SENSE ⑤ ⑥

**FIG. 4**

FIG. 5

**FIG. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19728295 A1

- DE 4436465 A1